# EUROPÄISCHE PATENTSCHRIFT

(11) **EP 3 381 125 B1**
(45) Veröffentlichungstag und Bekanntmachung des Hinweises auf die Patenterteilung: **03.07.2019**
(21) Anmeldenummer: 16791049.6
(22) Anmeldetag: 07.11.2016
(51) Int. Cl.: H03H 9/02, H01L 23/36, H01L 41/053, H03H 9/05, H03H 9/08

(54) **ELEKTRISCHES BAUELEMENT MIT WAERMEABLEITUNG**
ELECTRIC DEVICE WITH IMPROVED DISSIPATION OF HEAT
APPAREIL ELECTRIQUE AYANT UNE DISSIPATION THERMIQUE AMELIOREE

(30) Priorität: 24.11.2015 DE 102015120341
(43) Veröffentlichungstag der Anmeldung: 03.10.2018
(73) Patentinhaber: SnapTrack, Inc., San Diego, CA 92121 (US)
(72) Erfinder: SCHIEK, Maximilian, 82178 Puchheim (DE); BADER, Bernhard, 85579 Neubiberg (DE); CERANSKI, Christian, 81371 München (DE); JEWULA, Tomasz, 85570 Markt Schwaben (DE)
(74) Vertreter: Wegner, Hans
(86) Internationale Anmeldenummer: PCT/EP2016/076841
(87) Internationale Veröffentlichungsnummer: WO 2017/089107

(56) Entgegenhaltungen:
- EP-A1- 2 219 417
- JP-A- 2005 223 580
- JP-A- 2010 182 958
- US-A1- 2002 000 895
- US-A1- 2004 041 496
- US-A1- 2014 333 175
- US-A1- 2015 318 461

## Beschreibung

In nahezu jedem elektrischen Bauelement entsteht allein durch den inneren Widerstand des Bauelements Verlustwärme. Verlustwärme kann das gesamte Bauelement aufheizen oder lokal zu Hot Spots führen. Insbesondere bei geringer werdenden Leiterbahnquerschnitten kann die lokale Erwärmung stark ansteigen und zu Degradationseffekten führen, die zumindest die Lebensdauer dieser Bauelemente reduzieren. Eine Erwärmung des Bauelements kann aber auch die Bauelementeigenschaften in unzulässiger Weise beeinflussen, da diese oft temperaturabhängig sind.

Mit akustischen Wellen arbeitende Bauelemente, beispielsweise in SAW- oder BAW-Technologie, zeigen ein stark temperaturabhängiges Frequenzverhalten, das sich durch einen relativ hohen Temperaturkoeffizienten der Mittenfrequenz der Bauelemente ausdrückt.

BAW Resonatoren, auch als SMR (solidly mounted resonator) bezeichnet, sind mit Volumenwellen arbeitende Bauelemente, die eine zwischen zwei Elektroden angeordnete piezoelektrische Schicht aufweisen und auf einem Substrat angeordnet sind. Mit hilfe eines akustischen Reflektors oder Spiegels wird ein Abtauchen der Welle in das Substrat verhindert.

Auch FBAR Resonatoren sind mit Volumenwellen arbeitende Bauelemente, die freischwingend auf einer Membran aufgebracht sind, die einen Hohlraum im Substrat überspannt.

Bei diesen Bauelementen tragen sämtliche Energieanteile, die weder transmittiert noch reflektiert werden, zum Verlust bei, der entweder eine nicht beabsichtigte elektromagnetische Abstrahlung induziert, oder der sich als ohmscher Verlust eben in der genannten Erwärmung manifestiert. Verschiebt sich beispielsweise die Mittenfrequenz eines BAW- oder SAW-Filters, so können dadurch auch die ohmschen Verluste ansteigen, da das Filter nicht mehr auf der optimalen Frequenz arbeitet. Dies verstärkt den Effekt der unerwünschten Bauelementerwärmung. Es entsteht ein Regelkreis mit positiv verstärkter Rückkopplung.

Durch verschiedene Maßnahmen ist es möglich, den Temperaturkoeffizienten der Frequenz bei mit akustischen Wellen arbeitenden Bauelementen zu reduzieren. Doch auch im temperaturkompensierten Fall treten immer noch ohmsche Verluste auf, sofern keine Supraleitung vorliegt. Die dabei entstehende Wärme muss aus dem Filterchip abgeleitet werden, was insbesondere in gehäusten Bauelementen ein Problem darstellen kann. Bei bekannten Bauelementen ist man daher bemüht, thermisch gut leitende Materialien in die Gehäuse einzubauen, um die Wärmeabfuhr zu erleichtern.

JP 2005 223580 A offenbart ein akustisches Oberflächenwellenelement mit Oberflächenwellen-Vorrichtungsmustern 12, 13 auf der Hauptoberfläche einer piezoelektrischen Platte 11, welches eine Vielzahl von Aussparungen 14 auf der Rückseite der piezoelektrischen Platte und ein stark wärmeleitendes Material 15 auf der Rückseite umfasst, einschließlich der inneren Seiten der Vertiefungen.

Aufgabe der vorliegenden Erfindung ist es, eine weitere Verbesserung der Wärmeabfuhr von elektrischen Bauelementen anzugeben, die technisch einfach anwendbar und bei einer Vielzahl von Bauelementen einsetzbar ist.

Diese Aufgabe wird mit einem Bauelement nach Anspruch 1 gelöst. Vorteilhafte Ausgestaltungen der Erfindung gehen aus den Unteransprüchen hervor.

Eine erfindungsgemäßes Bauelement umfasst einen Chip, auf dem ein Verlustwärme erzeugendes Element angeordnet ist. Zur verbesserten Abführung der Verlustwärme ist auf dem Chip nahe dem Ort der Erzeugung eine Abstrahlschicht aufgebracht, die im thermischen Kontakt zu dem Verlustwärme erzeugenden Element steht. Die Abstrahlschicht weist eine vergrößerte Oberfläche auf, insbesondere eine aufgeraute Oberfläche oder eine Oberfläche mit einer 3D-Struktur.

Die Abstrahlschicht kann auf einer äußeren Oberfläche des Chips aufgebracht sein. Sie kann aber auch eine Grenzschicht sein, insbesondere ein Interface zu einer gut wärmeleitenden Schicht. In jedem Fall ist der Wärmetransport über die Abstrahlschicht der genannten aufgerauten oder anderweitig strukturierten Oberfläche gegenüber einer Schicht mit geringerer Oberfläche und insbesondere gegenüber einer planen Schicht verbessert. Gemäß einer bekannten Formel für die Wärmeübertragung an Kontaktflächen geht die Kontaktfläche als linearer Faktor ein, so dass die Wärmeabeleitung annähernd linear mit der Oberfläche ansteigt.

Gemäß einer Ausführungsform weist die Abstrahlschicht eine kolumnare Struktur auf und ist als polykristalline oder kristalline Schicht ausgebildet. Auf derartigen kristallinen oder polykristallinen Oberflächen können durch kristallachsenorientiertes Rückätzen unterschiedliche Kristallfacetten der polykristallinen oder kristallinen Schicht freigelegt werden, die gegen die Schichtebene geneigt sind und alleine dadurch die Oberfläche vergrößern.

Im Idealfall bildet sich über jeder kristallinen Phase eine Pyramidenspitze aus, sodass trotz aufgerauter Oberfläche mit einer Vielzahl von Pyramidenspitzen eine (aufgeraute) Schichtebene erhalten bleibt.

Ein bevorzugtes Material zur Ausbildung einer Abstrahlschicht weist eine hohe Wärmeleitfähigkeit auf. Vorzugsweise wird ein Material eingesetzt, welches mit dem Chip selbst bzw. mit den Herstellungsschritten des Bauelements kompatibel ist.

In einer Ausführungsform wird für die Abstrahlschicht Aluminiumnitrid eingesetzt, welches kolumnar aufgewachsen und an der Oberfläche so behandelt werden kann, dass die gewünschte aufgeraute Oberfläche mit Pyramidenspitzenstruktur erhalten wird. Aluminiumnitrid hat den weiteren Vorteil, dass es ein elektrischer Isolator ist. Selbst wenn eine solche Abstrahlschicht auf oder in die Nähe von elektrisch leitenden oder Strom führenden Elementen des Bauelements aufgebracht ist, werden dessen Eigenschaften durch Aluminiumnitrid nicht gestört. Unerwünschte kapazitive oder galvanische Verkopplungen können so nicht entstehen.

Des Weiteren hat Aluminiumnitrid den Vorteil, dass es als aufgebrachte Schicht gut strukturierbar ist. So ist es möglich, Abstrahlschichten auf genau begrenzten Flächen aufzubringen bzw. großflächig aufgebrachte Aluminiumnitridschichten so zu strukturieren, dass sie genau auf gewünschte Flächen begrenzt sind. Dies ist insbesondere für solche Bauelemente von Vorteil, die in bestimmten aktiven Bauelementbereichen nicht abgedeckt werden dürfen, ohne die Eigenschaften des Bauelements zu verändern.

Gemäß der Erfindung ist die Abstrahlschicht auf einem ersten Oberflächenbereich des Chips aufgebracht. Ein die Verlustwärme erzeugendes Element ist auf oder unterhalb eines zweiten Oberflächenbereichs des Chips angeordnet, wobei erster und zweiter Oberflächenbereich nebeneinander angeordnet sind. Erfindungsgemäße Bautelemente haben also den Vorteil, dass das Verlustwärme erzeugende Element nicht mit einer Materialschicht abgedeckt werden muss und dementsprechende Nachteile nicht in Kauf genommen werden müssen.

In der vorteilhaftesten Variante ist die Abstrahlschicht eine gut wärmeleitende Schicht, indem sie ein gut wärmeleitendes Material umfasst.

Gemäß der Erfindung ist vorgesehen, dass das Bauelement eine Abstrahlschicht auf aufgerauhte Oberfläche und eine Wärmeabstrahlschicht gemäß Anspruch 1 umfasst.

Gemäß der Erfindung ist vorgesehen, dass sich die Wärmeleitschicht über den ersten und zweiten Oberflächenbereich erstreckt, jedoch unterhalb der Abstrahlschicht und unterhalb des Verlustwärme erzeugenden Elements geführt wird, sodass sie dort eine Wärmeleitpfad vom Entstehungsort der Verlustwärme hin zur Abstrahlschicht ausbilden kann. Eine solche Wärmeleitschicht kann insbesondere ein Metall umfassen.

Vorteilhaft sitzt die Abstrahlschicht auf der Oberfläche des Chips auf, auf der auch das Verlustwärme erzeugende Element, insbesondere eine elektrisch leitende Struktur, angeordnet ist. Möglich ist es jedoch auch, über dem Verlustwärme erzeugenden Element eine Abdeckschicht anzuordnen, die entweder direkt auf dem Verlustwärme erzeugenden Element aufliegt oder dieses in einem sich unter der Abdeckschicht ausbildenden Hohlraum einschließt.

Die Abstrahlschicht kann auch auf der Oberfläche der Abdeckschicht aufgebracht sein.

Ein Anwendungsbeispiel einer solchen Abdeckschicht stellen so genannte Thin Film Packages dar, bei denen empfindliche Bauelementstrukturen unter Hohlraum bildenden Abdeckschichten verkapselt sind. Bei deren Herstellung wird zunächst eine strukturierte Opferschicht in den Bereichen aufgebracht, in denen ein Hohlraum entstehen soll. Diese Opferschicht wird anschließend mit einer Abdeckschicht abgedeckt und die Opferschicht selbst durch Löcher in der Abdeckschicht herausgelöst oder -geätzt. Anschließend werden die Löcher in der Abdeckschicht verschlossen. Es verbleiben verschlossene Hohlräume an den Stellen, an denen die strukturierte Opferschich aufgebracht war.

Solche Abdeckschichten können durch Verstärkungsschichten mechanisch weiter stabilisiert werden. Erfindungsgemäß kann die Abstrahlschicht zur mechanischen Verstärkung des Hohlraumgehäuses bzw. zur Verstärkung der Abdeckschicht eingesetzt werden. Der Wärmetransport von dem im Hohlraum eingeschlossenen Wärme erzeugenden Element kann dann zumindest zum Teil über die im Hohlraum eingeschlossene Atmosphäre hin zu der Abdeckschicht erfolgen und schließlich über die Abstrahlschicht in die Außenwelt.

Möglich ist es jedoch auch, die Abstrahlschicht im Randbereich der eingeschlossenen Hohlräume bis zur Chipoberfläche oder zumindest in die Nähe des Verlustwärme erzeugenden Elements zu führen, um den Wärmeleitpfad zwischen Verlustwärme erzeugendem Element und Abstrahlschicht zu verkürzen und damit die Wärmeleitung zu verbessern.

Vorteilhaft ist es also, wenn die Abdeckschicht nur die Kavität, also den Hohlraum im Gehäuse umschließt und seitlich der Kavität mit der Oberfläche des Chips abschließt. In diesem Fall kann dann auch die darauf aufgebrachte Abstrahlschicht mit der Oberfläche des Chips abschließen.

In einer Ausführungsform umfasst der Chip einen mit akustischen Volumenwellen arbeitende BAW oder FBAR Resonatoren. Mehrere solcher Resonatoren können in Serie und parallel zu einem Bandpassfilter verschaltet sein, sodass an einzelnen BAW-Resonatoren eine hohe elektroakustische Leistung anliegen kann, die zwangsläufig auch zur Erzeugung von Verlustwärme führt.

Eine auf den BAW-Resonator aufgebrachte Abstrahlschicht verbessert die Wärmeabstrahlung aus dem Resonator bzw. aus dem Chip. Die Abstrahlschicht kann dabei auf einer Oberfläche des BAW-Resonators aufgebracht sein, die nicht die Top-Elektrode umfasst. Dies hat den Vorteil, dass in diesen Bereichen die piezoelektrische Schicht freiliegt, die wiederum aus einem kristallinen Material und insbesondere aus Aluminiumnitrid besteht. In einer Ausführungsform ist es daher möglich, die neben der Top-Elektrode freiliegende Oberfläche der piezoelektrischen Schicht entsprechend aufzurauen, sodass die Abstrahlschicht aus dem freiliegenden Oberflächenbereich der piezoelektrischen Schicht herausgebildet wird. Möglich ist es jedoch auch, die Abstrahlschicht zusätzlich auf diesen Oberflächenbereich aufzubringen und dann entsprechend aufzurauen.

In einer weiteren Ausführungsform wird die Abstrahlschicht als ganzflächige Schicht auf den BAW-Resonator aufgebracht und bildet dann eine Teilschicht des Schichtenstapels, in dem sich die akustische Welle beim Betrieb des Resonators ausbreiten kann. Dann muss die Abstrahlschicht allerdings bei der Berechnung der Resonanzfrequenz mit einbezogen werden. Möglich ist es jedoch auch, die Abstrahlschicht dabei gleichzeitig als Trimmschicht zu verwenden, indem der Rückätzprozess zur Freilegung der zur Schichtebene geneigten Kristallflächen solange durchgeführt wird, bis der gewünschte Schichtabtrag und die damit verbundene Frequenzverschiebung, also der Trimmeffekt, erreicht ist.

In Abhängigkeit von den thermomechanischen Eigenschaften einer solchen als Trimmschicht genutzten Abstrahlschicht kann durch Reduktion der Schichtdicke sowohl eine Frequenzerhöhung als auch eine Frequenzerniedrigung der Resonanzfrequenz des BAW-Resonators erzielt werden.

Möglich ist es auch, dass der Chip ein SAW-Bauelement umfasst. Diese Bauelemente weisen ein piezoelektrisches Substrat auf, auf dem Bauelementstrukturen angeordnet sind, die zur Erzeugung, Wandlung, Propagation oder Reflexion von akustischen Oberflächenwellen dienen.

In einer beispielhaften Anordnung, die nicht Teil der Erfindung ist, wird die Abstrahlschicht direkt auf einen ersten Oberflächenbereich des piezoelektrischen Substrats aufgebracht, welcher sich nicht in den akustischen Pfad der Oberflächenwellen erstreckt. In diesem Fall bildet die Abstrahlschicht eine Massenbelegung in einem akustisch nicht aktiven Oberflächenbereich, wo sie für die Funktion des Bauelements völlig unbedenklich ist. Dabei ist es möglich, die Abstrahlschicht nahe an die Bauelementstrukturen heranzuführen und in einer Ausführung so zu strukturieren, dass Teile der Strom führenden Bus Bars oder der Strom führenden Zuleitungen und Kontaktpads von der Abstrahlschicht bedeckt werden.

In einer weiteren Ausführungsform umfasst das Bauelement einen SAW-Chip, bei dem über der die Bauelementstrukturen tragenden Oberfläche eine Isolatorschicht, insbesondere eine den Temperaturkoeffizienten der Mittenfrequenz kompensierende Schicht, aufgebracht ist, insbesondere eine SiO₂-Schicht. Über diese SiO₂-Schicht kann nun zusätzlich noch die Abstrahlschicht aufgebracht werden, die im Vergleich zur SiO₂-Schicht eine vernachlässigbare zusätzliche Massenbelastung zur Folge hat, die wenig oder keinen Effekt auf die akustischen Eigenschaften des SAW-Bauelements ausübt. Auf diese Weise wird ein guter Wärmetransport von den Bauelementstrukturen, in denen die Verlustwärme produziert wird, durch die Kompensationsschicht hindurch in die Abstrahlschicht und von dieser in die Umgebung ermöglicht. Die relativ große Oberfläche der Abstrahlschicht verbessert die Wärmeabstrahlung in die Umgebung.

Bauelemente wie insbesondere SAW- und BAW-Bauelemente können in Flip-Chip-Bauweise auf einem Träger montiert werden. In dieser Anordnung weisen die Bauelementstrukturen tragenden Oberflächen hin zum Träger und sind daher in einem Luftspalt zwischen Chip und Träger angeordnet. In einer solchen Anordnung kann nun eine erste Abstrahlschicht auf der zum Träger weisenden Oberfläche des Bauelementchips und eine weitere Abstrahlschicht auf der zum Chip weisenden Oberfläche des Trägers angeordnet werden. Die vergrößerte Oberfläche der Abstrahlschicht erlaubt einen verbesserten Wärmetransport in beide Richtungen, also nicht nur von der (ersten) Abstrahlschicht in die Umgebung, sondern auch von der Umgebung in die (weitere) Abstrahlschicht, was allein vom Temperaturgradienten abhängig ist.

Eine Abstrahlschicht kann in dieser Anordnung daher auch als Wärmeaufnahmeschicht dienen, sodass ein besserer Wärmetransport durch den Spalt zwischen Bauelementchip und Träger in den Träger hinein ermöglicht wird. Im Träger selbst können gut wärmeleitende Schichten, insbesondere metallische Leiterbahnen und metallische Flächen einen weiteren Wärmepfad ausbilden, der letztendlich über vertikale Metallstrukturen, insbesondere Vias oder andere Durchkontaktierungen auch bis zur Bodenseite des Trägers geführt werden. Von der Bodenseite des Trägers kann die Wärme über Lötkontakte in eine Schaltungsumgebung abgeführt werden. Möglich ist es jedoch auch, dass der Träger mit seinen elektrisch leitenden Strukturen eine ausreichend große Wärmesenke darstellt, die ausreichend Verlustwärme aufnehmen kann, ohne sich dabei unzulässig zu erwärmen.

Neben den bereits beschriebenen vorzugsweise kristallinen oder polykristallinen Abstrahlflächen mit behandelter und insbesondere rückgeätzter Oberfläche sind jedoch auch andere Materialien zur Ausbildung der Abstrahlschicht geeignet, die eine raue Oberfläche ausbilden.

Z.B. sind alle Materialien geeignet, die zum einen eine ausreichende Wärmeleitfähigkeit aufweisen und zum anderen Schichten mit hoher spezifischer Oberfläche, also eine Wärme abstrahlende Oberfläche, ausbilden können. Möglich ist es zum Beispiel, eine Abstrahlschicht aus einzelnen Partikeln auszubilden. Diese können beispielsweise in einer dünnen Schicht eines Binders oder in einem Lack dispergiert sein. Vorzugsweise ist die Konzentration der Partikel in der Binderschicht so hoch, dass die Partikel aus der Schicht herausragen und eine große Oberfläche ausbilden.

Aus Lackschichten mit ausreichend großen Füllstoffpartikeln und hohem Lösungsmittelanteil lässt sich beispielsweise durch Entfernen des Lösungsmittels die Schichtdicke soweit reduzieren, bis die darin enthaltene Füllstoffpartikel über der Lackschicht hervorstehen.

Möglich ist es jedoch auch, die Abstrahlschicht aus Materialien herzustellen, die partikelförmig aufgebracht werden können. Möglich sind z. B. Pulverbeschichtungen, die zur besseren Verfestigung noch gesintert werden können.

Ein Material mit hoher Wärmeleitfähigkeit und großer Oberfläche ist auch Kohlenstoff, insbesondere Ruß.

Das Aufbringen von Partikeln zur Erzeugung einer Abstrahlschicht mit hoher Oberfläche kann auch mittels eines Partikelstrahls erfolgen, bei dem allein die kinetische Energie der in Richtung Oberfläche eines Substrats beschleunigten Partikel ausreicht, eine Schicht von ausreichendem Schichtzusammenhalt und ausreichender Schichtfestigkeit auszubilden.

Auch Aufsprühen, Aufdampfen oder Aufjetten sind als Verfahren zur Herstellung einer Abstrahlschicht geeignet. Ein als Lack oder Dispersion oder Suspension vorliegendes Material kann auch aufgedruckt oder aufgestrichen werden.

Mittels eines Jetdruckverfahrens kann das Aufbringen einer Abstrahlschicht auch strukturiert erfolgen, sodass keine nachträgliche Strukturierung der Abstrahlschicht erforderlich ist und diese ausschließlich in den Bereichen aufgebracht werden kann, in denen sie die Bauelementfunktion nicht stört.

Im Folgenden wird die Erfindung anhand von Ausführungsbeispielen und der dazugehörigen Figuren näher erläutert. Die Figuren sind teils schematisch und nicht maßstabsgetreu ausgeführt. Einzelne Teile können zur besseren Veranschaulichung größer oder kleiner dargestellt sein. Den Figuren sind daher weder absolute noch relative Maßangaben zu entnehmen.
Figur 1 zeigt einen schematischen Querschnitt durch ein Bauelement gemäß einem Beispiel, das nicht Teil der Erfindung ist,
Figur 2 zeigt eine Fotografie einer als Abstrahlschicht tauglichen, polykristallinen, aufgerauten Schicht,
Figur 3 zeigt einen schematischen Querschnitt durch ein Bauelement gemäß eines Beispiels, das nicht Teil der Erfindung ist,
Figur 4 zeigt einen schematischen Querschnitt durch ein Bauelement gemäß eines Ausführungsbeispiels,
Figur 5 zeigt die Draufsicht auf ein Bauelement gemäß eines Anwendungsbeispiels, bei dem nicht alle Merkmale der Erfindung gemäß Anspruch 1 vorhanden sind,
Figur 6 zeigt ein Bauelement gemäß eines Anwendungsbeispiels, bei dem nicht alle Merkmale der Erfindung gemäß Anspruch 1 vorhanden sind,
Figur 7 zeigt ein Bauelement gemäß eines Anwendungsbeispiels, bei dem nicht alle Merkmale der Erfindung gemäß Anspruch 1 vorhanden sind,
Figur 8 zeigt ein Anwendungsbeispiel, bei dem nicht alle Merkmale der Erfindung gemäß Anspruch 1 vorhanden sind,
Figur 9 zeigt ein Anwendungsbeispiel, bei dem nicht alle Merkmale der Erfindung gemäß Anspruch 1 vorhanden sind,
Figur 10 zeigt eine Draufsicht auf ein Bauelement mit strukturierter Abstrahlschicht,
Figur 11 zeigt die Wärmeverteilung in einem Anwendungsbeispiel, bei dem nicht alle Merkmale der Erfindung gemäß Anspruch 1 vorhanden sind,
Figur 12 zeigt ein weiteres Ausführungsbeispiel der Erfindung anhand eines schematischen Querschnitts.

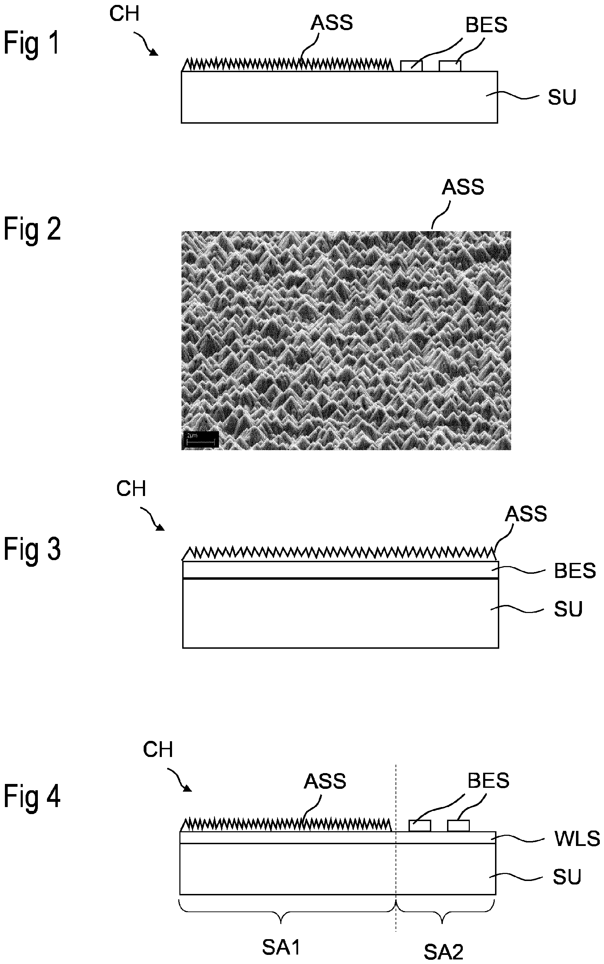

Ein einfaches Beispiel, welches nicht Teil der Erfindung ist, ist in Figur 1 im schematischen Querschnitt dargestellt. Das Bauelement umfasst einen Chip CH, der im Wesentlichen aus einem Substrat SU und darauf aufgebrachten Bauelementstrukturen BES besteht. Die Bauelementstrukturen sind Strom führend und erzeugen im Betrieb des Bauelements Verlustwärme. Zur schnelleren Abführung der Verlustwärme ist auf der Oberfläche des Substrats eine Abstrahlschicht ASS aufgebracht, die im gezeigten Ausführungsbeispiel einen ersten Oberflächenbereich des Chips CH belegt, in dem keine Bauelementstrukturen BES angeordnet sind. Die Abstrahlschicht ist eine vorzugsweise dünne Schicht, die mit großer Oberfläche ausgebildet ist. Insbesondere umfasst die Abstrahlschicht ein Material, welches eine bessere thermische Leitfähigkeit als das Substrat SU aufweist.

Die Abstrahlschicht zeigt vorzugsweise keinerlei Wechselwirkung mit den Bauelementstrukturen und ist vorzugsweise ein Isolator, der dementsprechend keine elektromagnetischen Wechselwirkung mit den Bauelementstrukturen BES oder anderen Strom führenden Elementen ausübt.

Figur 2 zeigt eine rasterelektronenmikroskopische Aufnahme einer polykristallinen Oberfläche, die als Abstrahlschicht ASS eingesetzt werden kann. Die beispielhafte Abstrahlschicht ASS ist ein kristallines Material, welches kristallachsenorientiert aufgewachsen ist und daher eine kolumnare Struktur aufweist. Die Oberfläche einer solchen kristallinen bis polykristallinen Schicht lässt sich Kristallflächen-orientiert rückätzen, wobei unterschiedliche Kristallflächen und Kristallfacetten der in der Schicht enthaltenden Kristallite freigelegt werden.

Das kolumnare Wachstum einer als ASS geeigneten polykristallinen Schicht wird begünstigt durch:
- Vorsehen einer geeigneten Wachstumsschicht, die unter der polykristallinen Schicht vorgesehen wird und die insbesondere eine passende Gitterstuktur aufweist, z.B. eine Gitterstruktur, die zur Gitterstruktur von AlN passt.
- Plane Ausführung der Wachstumsschicht.
- Vermeidung von Verunreinigungen auf Oberflächen (z. B. durch vorherige Prozessschritte) auf und unter der Wachstumsschicht.

Während des Aufbringens, z.B. durch einen Sputterprozess, wird das kolumnare Wachstum durch eine niedrige Aufwachsgeschwindigkeit gefördert. Dabei wachsen zuerst feine voneinander getrennte Kristallite. Bei weiterem Wachstum waschen die Kristallite zusammen. Insgesamt wachsen dann die kristallographisch relativ zur Oberfläche ausgerichteten Gebiete schneller, so dass in diese Richtung orientierte Kristalldomänen schließlich dominieren und eine Schicht mit Kolumnarstruktur entsteht. Die einzelnen Domänen können dann noch gegenenader verdreht sein, haben aber überwiegend parallel ausgerichtete C-Achsen.

Ein Zuspitzen der Kristallite gelingt durch kristallachsen orientiertes Rückätzen, wobei Kristallflächen der Einheitszelle freigelegt werden, die regelmäßig ausgerichtet sind und entsprechende Neigungswinkel zur Schichtebene aufweisen. Nahezu unabhängig vom Kristallgitter bilden sich dabei in fast allen Fällen pyramidenförmige Spritzen aus, die jeweils Kristallkanten bzw. Ecken der Einheitszelle entsprechen.

Mit besonderem Vorteil wird eine aufgewachsene Kristallschicht erst vorgeätzt und dann in einem Nachätzschritt mit einem nass-chemischen oder gasförmigen Ätzmittel behandelt, das vorwiegend an Kristalldefekten ätzt und unterschiedliche Kristallfacetten der Kristallschicht selektiv ätzt.

Besonders bevorzugt eignet sich dazu das nass-chemische Ätzmittel KOH. Als gasförmiges Ätzmittel eignet sich beispielsweise ein korrosives Gas wie H oder Cl. Bevorzugt wird H als Ätzgas bei einer erhöhten Temperatur, insbesondere größer oder gleich 800°C, verwendet.

Bevorzugt wird bei dem Vorätzschritt nass-chemisch geätzt. Als Ätzmittel ist insbesondere KOH in verdünnter Form geeignet. Bei einer besonders bevorzugten Ausgestaltung der Erfindung wird bei diesem Ätzschritt KOH mit einer Konzentration von 5% bei Raumtemperatur verwendet, wobei die Ätzdauer zwischen 5 min und 15 min liegt.

Alternativ eignet sich für den Vorätzschritt auch beispielweise ein Trockenätzverfahren (RIE-Verfahren). Ein Trockenätzverfahren wirkt in der Regel gerichtet, so dass bei dieser Ausgestaltung der Erfindung Oberflächenunebenheiten in die Kristallschicht übertragen und so eine Aufrauung dieser Schicht erzielt wird.

Bei dem Vorätzschritt werden unterschiedliche Kristallfacetten freigelegt. Danach wird in einem Nachätzschritt mit einem weiteren nass-chemischen Ätzmittel behandelt das vorwiegend an Kristalldefekten ätzt und unterschiedliche Kristallfacetten an der Oberfläche selektiv ätzt. Das weitere nass-chemische Ätzmittel enthält im Beispielfall KOH. Durch die Behandlung mit KOH kann die Oberfläche sehr effektiv aufgeraut werden. Die beim Vorätzen erzeugte Rauhigkeit wird hinsichtlich Effizienz für die Wärmeabstrahlung der Abstrahlschicht erheblich verbessert.

Bevorzugt wird bei dem Nachätzschritt KOH in konzentrierter Form als Ätzmittel verwendet. Bei einer weiter bevorzugten Ausgestaltung der Erfindung wird hierbei mit KOH mit einer Konzentration von 25% bei einer Temperatur zwischen 70°C und 90°C, beispielsweise bei 80°C, geätzt, wobei die Ätzzeit zwischen 3 min und 10 min liegt.

Alternativ kann für den Nachätzschritt als Ätzmittel ein korrosives Gas, beispielsweise H oder Cl, verwendet werden. Die Figur zeigt die Oberfläche der Abstrahlschicht ASS, die eine Vielzahl genau dieser spitzen Pyramiden aufweist, deren Seitenflächen Kristallfacetten sind, die parallel zu unterschiedlichen Kristallebenen des Einheitskristalls ausgerichtet sind. Ein beispielhaftes Material, welches mit einer solchen Struktur versehen werden kann, ist Aluminiumnitrid. Es sind jedoch weitere kristallin oder polykristallin aufwachsende Materialien bekannt, die sich in der gleichen Weise mit einer rauen pyramidenförmigen Struktur versehen lassen. Beispielhaft seien hierfür nur Galliumnitride, Aluminiumoxid, Siliziumoxid, Siliziumkarbit und amorpher Kohlenstoff genannt, die in gleicher Weise Verwendung finden können, um eine Abstrahlschicht mit erhöhter Oberfläche auszubilden.

Figur 3 zeigt anhand eines schematischen Querschnitts einen weiteren Chip CH, bei dem auf einem Substrat SU eine großflächige Bauelementstruktur BES angeordnet ist, beispielsweise eine plattenförmige Elektrode. Zur Verbesserung der Wärmeabführung aus dem einen Chip CH umfassenden Bauelement ist auf die Bauelementstruktur BES eine Abstrahlschicht ASS aufgebracht, die sich ebenfalls durch ihre raue und damit vergrößerte Oberfläche auszeichnet. Diese Anordnung kommt für Bauelemente in Betracht, die durch Aufbringen einer zusätzlichen Schicht nicht in ihrer Funktion behindert werden oder bei denen die Wechselwirkung zwischen Abstrahlschicht ASS und dem Bauelement kontrolliert werden kann, sodass die Bauelementeigenschaften trotz zusätzlicher Schicht reproduzierbar einstellbar sind.

Als Beispiel für eine solche Anwendung seien Kondensatoren, keramische Widerstände, Varistoren oder Thermistoren genannt, die allesamt Bauelement darstellen, die im bestimmungsgemäßen Betrieb des Bauelements ausreichend Verlustwärme erzeugen und zu einer Aufheizung des Bauelements führen, die sinnvollerweise gut und schnell abzuführen ist. Mit der erfindungsgemäßen Abstrahlschicht wird die Wärmeabgabe aus dem Bauelement an die Umgebung verbessert.

Wenn die Umgebung wie im dargestellten Beispiel Luft umfasst, so ist die Abstrahlung insbesondere im Infrarotbereich, also gerade im Bereich der Wärmestrahlung, verbessert.

Ein weiteres Bauelement, das mit dem dargestellten Aufbau zu einer verbesserten Wärmeabführung führt, ist ein BAW-Resonator, der einen Schichtaufbau aufweist und dessen oberste Elektrodenschicht die dargestellte Bauelementstruktur BES darstellt. Bei ausreichend hoher Schichtdickengleichmäßigkeit der Abstrahlschicht ASS werden die akustischen Eigenschaften des BAW-Resonators nicht unzulässig beeinflusst.

Figur 4 zeigt einen Bauelementchip CH gemäß einem Ausführungsbeispiel im schematischen Querschnitt. Der Chip CH umfasst ein Substrat SU, auf dem Bauelementstrukturen BES aufgebracht sind. Im Unterschied zu Figur 1 ist jedoch zwischen Substrat SU und Bauelementstruktur BES eine Wärmeleitschicht WLS angeordnet. Die Wärmeleitschicht erstreckt sich über einen ersten Oberflächenbereich SA1 mit der Absstrahlschicht ASS und einen zweiten Oberflächenbereich SA2 mit den Bauelementstrukturen BES und stellt somit einen Wärmeleitpfad zwischen den Wärme erzeugenden Bauelementstrukturen BES und der Abstrahlschicht ASS dar. Auf diese Weise ist der Wärmetransport von den Bauelementstrukturen zur Abstrahlschicht verbessert.

Für die Ausführung ist es von Vorteil, wenn die Wärmeleitschicht WLS ein Isolator ist oder zumindest gegen die Bauelementstrukturen elektrisch isoliert ist, z.B. mittels einer Isolatorschicht (in der Figur nicht dargestellt. In einer Ausführungsform können Wärmeleitschicht WLS und Abstrahlschicht ASS das gleiche Material umfassen wie z. B. Aluminiumnitrid, welches einen elektrischen Isolator mit hoher Wärmeleitfähigkeit darstellt.

In einer nicht dargestellten Abwandlung dieses Ausführungsbeispiels ist es möglich, als Wärmeleitschicht WLS ein Material einzusetzen, welches durch entsprechende Aufbring- oder Nachbehandlungsverfahren mit einer großen Oberflächen versehen werden kann. Im ersten Oberflächenbereich SA1 kann die Wärmeleitschicht dann die genannte Nachbehandlung erfahren, wobei sich die Oberfläche entsprechend aufraut bzw. vergrößert. Es ist daher nicht erforderlich, auf eine solche Wärmeleitschicht WLS eine zusätzliche Abstrahlschicht aufzubringen, sondern allein den ersten Oberflächenbereich der Wärmeleitschicht durch Aufrauen in eine Abstrahlschicht zu überführen.

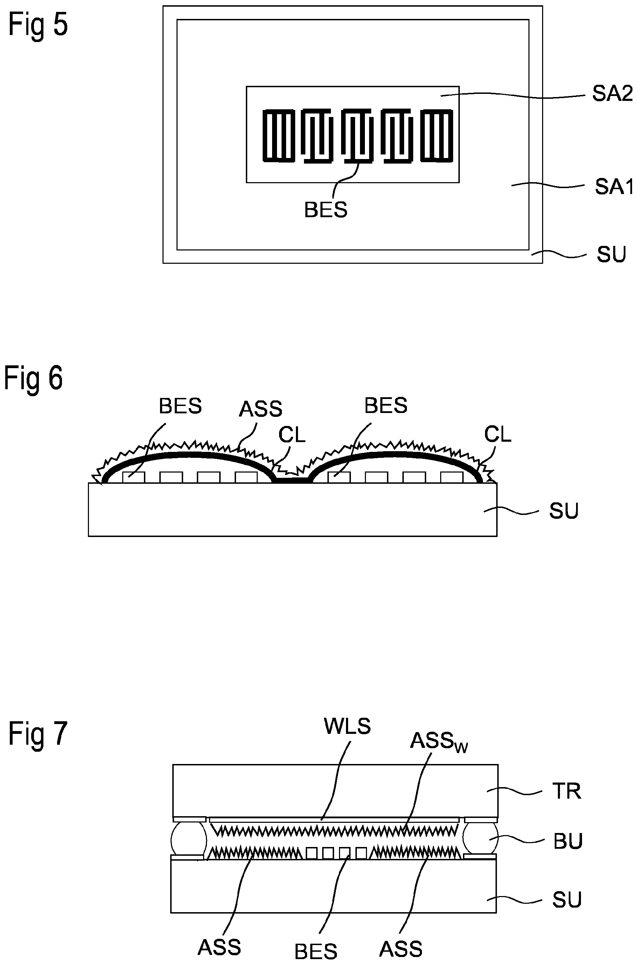

Figur 5 zeigt eine Draufsicht auf ein SAW-Bauelement, welches vorteilhaft mit einer Abstrahlschicht ASS in einem ersten Oberflächenbereich SA1 versehen werden kann. Die Bauelementstrukturen BES sind auf einem piezoelektrischen Substrat SU in Form streifenförmiger Metallisierungen aufgebracht. Die Bauelementstrukturen bilden eine akustische Spur aus, in der zumindest ein Interdigitalwandler zwischen zwei Reflektoren angeordnet ist. Die akustische Oberflächenwelle ist zwischen den beiden Reflektoren ausbreitungsfähig, sodass die beiden Reflektoren den akustischen Pfad begrenzen. Der zweite Oberflächenbereich SA2 umfasst daher zumindest die akustische Spur. Der erste Oberflächenbereich SA1 dagegen, auf dem die Abstrahlschicht ASS aufgebracht oder erzeugt ist, spart den zweiten Oberflächenbereich aus, sodass die Abstrahlschicht ASS nicht in akustische Wechselwirkung mit der akustischen Oberflächenwelle tritt. Es ist möglich, die Abstrahlschicht ASS als zusätzliche Schicht auf das Substrat im ersten Oberflächenbereich SA1 aufzubringen. Möglich ist es jedoch auch, das Substrat im ersten Oberflächenbereich SA1 entsprechend zu strukturieren und so mit einer vergrößerten Oberfläche zu versehen.

Figur 6 zeigt ein Bauelement anhand eines schematischen Querschnitts. Das Bauelement ist in einem Thin Film Package verkapselt. Das Bauelement umfasst ein Substrat SU, auf dem Bauelementstrukturen BES aufgebracht sind. Die Bauelementstrukturen sind mechanisch empfindlich und müssen so verkapselt werden, dass sich ein Hohlraum über den Bauelementstrukturen ausbildet.

Das dazu verwendete Thin Film Package umfasst eine großflächig über den Bauelementstrukturen aufgebrachte Abdeckschicht CL, unter der mit Hilfe einer Opferschicht, die später herausgelöst wird, Hohlräume zur Aufnahme der Bauelementstrukturen ausgebildet sind. Auf dieser Abdeckschicht CL kann nun eine Abstrahlschicht ASS aufgebracht werden. Die Wärmeableitung erfolgt dabei von den Bauelementstrukturen zum Teil über den im Hohlraum eingeschlossenen Luftspalt hinweg durch die Abdeckschicht CL hin zur Abstrahlschicht ASS, von der es aufgrund der vergrößerten Oberfläche schneller abgeführt werden kann.

Ein zweiter Teil der Verlustwärme, die in den Bauelementstrukturen erzeugt wird, wird über die Substratoberfläche direkt in die Abdeckschicht CL und von dort in die Abstrahlschicht ASS geleitet. Dazu ist die Abdeckschicht CL im Bereich zwischen unterschiedlichen Bauelementstrukturen bis auf die Oberfläche des Substrats SU oder zumindest bis in dessen Nähe geführt.

Alternativ ist die Abdeckschicht in gut wärmeleitender Verbindung mit der Oberfläche des Substrat, beispielsweise über thermisch gut leitende Strukturen, wie etwa über metallische Strukturen. Die Abdeckschicht CL kann eine organische Schicht sein. Vorzugsweise umfasst sie jedoch eine selektiv gegen die Opferschicht ätzbare keramische Schicht.

Figur 7 zeigt anhand eines schematischen Querschnitts ein Bauelement mit verbesserter Wärmeabführung. Das Bauelement umfasst einen Bauelementchip mit einem Substrat SU, auf dessen Oberfläche Bauelementstrukturen BES angeordnet sind. Im nicht von den Bauelementstrukturen BES belegten Oberflächenbereich des Substrats, also im ersten Oberflächenbereich SA1, ist eine Abstrahlschicht ASS aufgebracht oder erzeugt. Ebenfalls vom ersten Oberflächenbereich SA1 ausgespart sind elektrische Kontaktflächen, über die der Chip auf einem Träger TR montiert ist.

Zur elektrischen und mechanischen Verbindung dienen Bumps BU, die als Lotbumps oder Studbumps ausgebildet sind. Der das Substrat SU umfassende Bauelementchip ist so auf dem Träger TR montiert, dass die Bauelementstrukturen BES zum Träger TR weisen. Auf der zum Substrat weisenden Oberfläche des Trägers TR ist eine weitere Abstrahlschicht ASS_{W} angeordnet, die den Wärmetransport in umgekehrter Richtung erleichtert, also vom Luftspalt zwischen Substrat und Träger in den Träger hinein.

Unterhalb der weiteren Abstrahlschicht ASS ist auf der Oberfläche des Trägers TR eine Wärmeleitschicht WLS vorgesehen, beispielsweise eine metallische Schicht. Im Träger selbst ist zumindest eine Metallisierungsebene vorgesehen, über die eine Verschaltung unterschiedlicher Bauelementstrukturen, die über die Bumps elektrisch angeschlossen sind, unterschiedlicher Chips oder nicht dargestellter passiver Elemente ermöglicht wird.

Weiter können Durchkontaktierungen auf die in der Figur nach oben weisende Oberfläche geführt sein, auf der Kontakte zur Verbindung mit einer Schaltungsumgebung vorgesehen sind (in der Figur nicht dargestellt). Dabei ist es möglich, zum einen die zur elektrischen Leitung vorgesehenen metallischen Strukturen innerhalb des Trägers zur Wärmeableitung zu nutzen. Zusätzlich sind allein der Wärmeableitung dienende metallische Wärmeleitpfade möglich, die auf eine äußere Oberfläche der Anordnung führen.

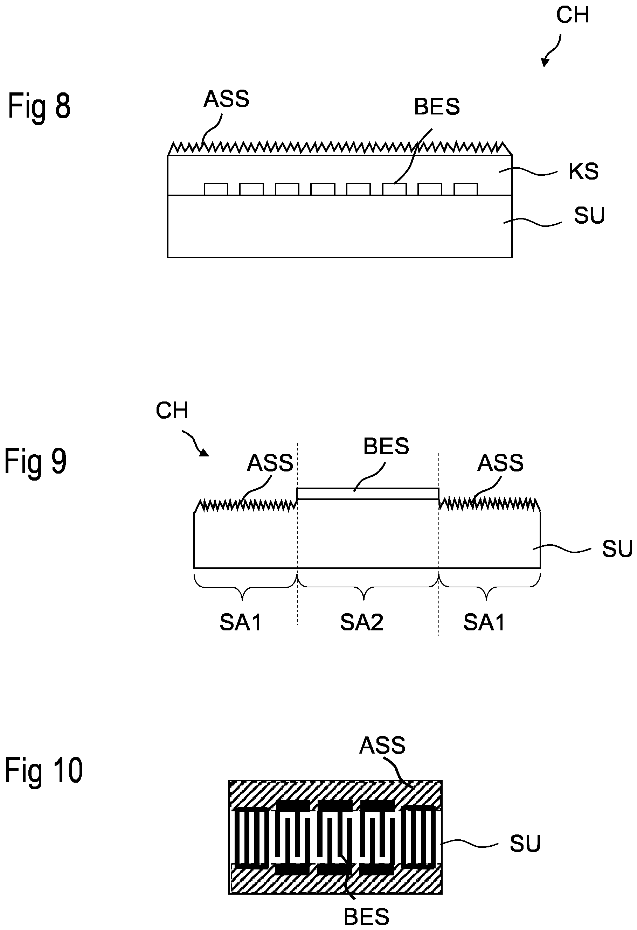

Figur 8 zeigt einen schematischen Querschnitt. Auch hier umfasst der Chip wieder ein Substrat SU mit Bauelementstrukturen BES. Die Bauelementstrukturen sind allerdings mit einer Kompensationsschicht KS abgedeckt, beispielsweise einer Siliziumoxidschicht, die zur Kompensation des Temperaturkoeffizienten TCF der Frequenz dient.

Auf der Oberfläche der Kompensationsschicht KS ist eine Abstrahlschicht ASS aufgebracht, deren Dicke vorzugsweise klein ist im Verhältnis zur Dicke der Kompensationsschicht KS. Möglich ist es auch, die Kompensationsschicht KS an der Oberfläche entsprechend aufzurauen und so in eine Abstrahlschicht ASS überzuführen, sodass sich die zusätzliche Aufbringung einer Abstrahlschicht erübrigt.

Das Bauelement kann als SAW-Bauelement ausgeführt sein, wobei die Bauelementstrukturen Interdigitalwandler und/oder Reflektoren darstellen.

Das Bauelement kann ein Halbleiter-Bauelement darstellen und der Chip ein Halbleitersubstrat und darauf angeordnete und/oder darin integrierte Bauelementstrukturen umfasst. Insbesondere kann der Chip eine integrierte Schaltung umfasssen.

Figur 9 zeigt einen schematischen Querschnitt durch einen Chip CH, welches in Verbindung mit den vorherigen Figuren bereits als nicht dargestellte Alternative erläutert wurde. Es ist in den ersten Oberflächenbereichen SA1 die Oberfläche des Substrats SU aufgeraut und stellt somit eine Abstrahlschicht ASS dar, die daher nicht separat aufgebracht werden muss. Der Bereich der Bauelementstrukturen BES entsprechend dem zweiten Oberflächenbereich SA2 ist von der aufrauenden Behandlung ausgespart, um eine Wechselwirkung mit der Bauelementfunktion zu vermeiden.

Figur 10 zeigt eine Draufsicht auf ein SAW-Bauelement, bei der sich der erste Oberflächenbereich SA1, auf dem eine Abstrahlschicht ASS erzeugt oder aufgebracht ist, über einen Teil der Bauelementstrukturen BES erstreckt. In der Figur 10 dargestellt ist eine Überlappung der Abstrahlschicht ASS mit den Bus Bars (Stromschienen) der Interdigitalwandler, was zum einen einen guten thermischen Kontakt mit den Bauelementstrukturen gewährleistet und zum anderen keine Beeinträchtigung der akustischen Spur darstellt, die sich nicht bis in die Bus Bars der Interdigitalwandler erstreckt.

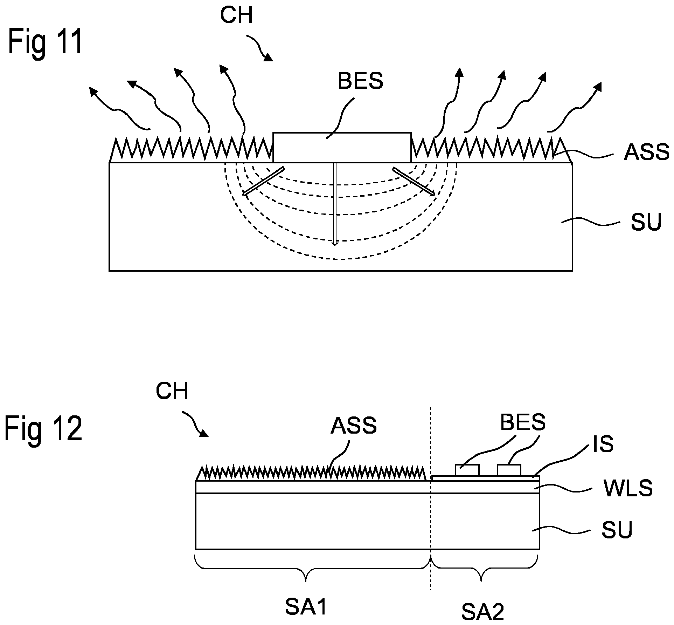

Figur 11 zeigt eine beispielhafte Temperaturverteilung innerhalb eines Bauelementchips CH mit aufgebrachter Abstrahlschicht ASS anhand von Isothermen. Die Bauelementstrukturen BES, die das Verlustwärme erzeugende Element darstellen, weisen im Betrieb des Bauelement auch den Bereich höchster Temperatur auf.

Die Isothermen erstrecken sich durch das Substrat SU und stellen Linien, die sich auf gleicher Temperatur befinden. Durch Pfeile ist der sich einstellende Temperaturgradient angedeutet, der radial von den Bauelementstrukturen BES weg weist.

Da über die Abstrahlschicht ASS eine verbesserte Wärmeabführung an die Umgebung erfolgt, dargestellt mit Schlangenlinien, stellt sich in lateraler Richtung von den Bauelementstrukturen weg weisend ein stärkerer Temperaturgradient ein, welcher ebenfalls die Wärmeabstrahlung über die Abstrahlschicht ASS verbessert.

Figur 12 zeigt eine weitere Ausführungsvariante eines erfindungsgemäßen Bauelements. Hier ist ähnlich wie im Ausführungsbeispiel gemäß Figur 4 ganzflächig auf dem Substrat SU eine Wärmeleitschicht WLS aufgebracht, die hier ein Metall oder ein anderes elektrisch leitfähiges Material umfassen kann. Um hier einen Kurzschluss der Bauelementstrukturen zu vermeiden, ist zwischen Bauelementstrukturen BES und Wärmeleitschicht WLS eine Isolationsschicht IS angeordnet. Diese kann sich über die gesamte Wärmeleitschicht WLS erstrecken, ist vorteilhaft jedoch nur im zweiten Oberflächenbereich SA2, also unterhalb der Bauelementstrukturen BES, angeordnet. Im ersten Oberflächenbereich SA1 ist die Abstrahlschicht ASS aufgebracht.

Alternativ, aber nicht gemäß der Erfindung, ist die Oberfläche der Wärmeleitschicht WLS entsprechend aufgeraut und keine separate Abstrahlschicht ASS aufgebracht.

Obwohl in den Figuren nicht separat dargestellt, kann die verbesserte Wärmeabführung aus dem Bauelement mit zusätzlichen Maßnahmen kombiniert werden, die aus dem Stand der Technik bekannt sind. So kann z. B. zusätzliche Wärmeableitung über gut Wärme leitende Strukturen, insbesondere über Kontaktpads, Bumps und andere elektrisch leitende Strukturen erfolgen, was die verbesserte Wärmeabstrahlung über die Abstrahlschicht ASS nicht behindert und gut mit dieser kombiniert werden kann. Vorteilhaft ist es dann jedoch, die Abstrahlschicht nahe an diese Wärme leitenden Strukturen heranzuführen, um auch diesen Wärmekontaktfluss zu verbessern und die Gesamtwärmeabführung zu verbessern.

Die Erfindung konnte nur anhand weniger Ausführungsbeispiele dargestellt werden und ist daher nicht auf diese beschränkt. Die Erfindung ist auf einer Vielzahl unterschiedlicher Bauelemente realisierbar, kann mit unterschiedlichen Materialien für Abstrahlschicht und Substrat ausgeführt werden.

Die aufgeraute bzw. vergrößerte Oberfläche der Abstrahlschicht kann wie beschrieben durch eine spezielle Behandlung erzeugt sein auch oder alternativ eine materialimmanent Schichteigenschaft sein.

Insbesondere Partikel umfassende Schichten mit über der Schichtebene herausragenden Partikelsegmenten weisen ebenfalls eine raue und damit erhöhte Oberfläche auf.

Die Abstrahlschichten können mechanisch feste oder eher locker aufsitzende Schichten sein, da sie keinen mechanischen Belastungen ausgesetzt sind. Die Abstrahlschichten können elektrisch isolierend oder elektrisch leitend sein, wobei im letzten Fall ein elektrischer Kontakt mit den Bauelementstrukturen ausgeschlossen werden kann. Alternativ können auch flächige Bauelementstrukturen BES mit aufgerauter Oberfläche als Abstrahlschicht fungieren, bzw. Abstrahlschichten Bauelementfunktion mit übernehmen.

### Bezugszeichenliste

- CH: Chip, umfasst
- SU: Substrat und darauf
- BES: Bauelementstrukturen (Verlustwärme erzeugendes Element)
- ASS: Abstrahlschicht (= wärmeabstrahlende Schicht)
- SA1: erster Oberflächenbereich (mit ASS)
- SA2: zweiter Oberflächenbereich (ohne ASS)
- WLS: zusätzliche Wärmeleitschicht, bildet
- CL: Abdeckschicht
- TR: Träger
- ASS_{W}: weitere Abstrahlschicht (wärmeabstrahlende Schicht) auf Träger
- BU: Bump
- KS: Hilfsschicht, z.B. TCF Kompensationsschicht
- IS: Isolierschicht (Fig. 12)

## Patentansprüche

1. Elektrisches Bauelement mit verbesserter Wärmeableitung,
mit einem Chip (CH), der ein Verlustwärme erzeugendes Element umfasst
mit einer auf dem Chip aufgebrachten Wärmeabstrahlschicht (ASS), die in thermischem Kontakt zu dem Verlustwärme erzeugenden Element steht
wobei die Wärmeabstrahlschicht eine aufgeraute Oberfläche aufweist;
bei dem die Wärmeabstrahlschicht (ASS) auf einem ersten Oberflächenbereich (SA1) des Chips aufgebracht ist,
bei dem das Verlustwärme erzeugende Element auf einem zweiten Oberflächenbereich (SA2) des Chips angeordnet ist,
wobei erster und zweiter Oberflächenbereich nebeneinander angeordnet sind; und
bei dem sich eine zusätzliche Wärmeleitschicht (WLS) über den ersten und zweiten Oberflächenbereich (SA1,SA2) erstreckt, die auf dem Chip (CH) aber unterhalb der Wärmeabstrahlschicht (ASS) und dem Verlustwärme erzeugendem Element einen Wärmeableitpfad ausbildet.

2. Bauelement nach Anspruch 1,
bei dem die Wärmeabstrahlschicht (ASS) eine kolumnare Struktur aufweist und als polykristalline oder kristalline Schicht ausgebildet ist.

3. Bauelement nach Anspruch 2,
bei dem die Wärmeabstrahlschicht (ASS) eine AlN Schicht ist, die durch kristallachsenorientiertes Rückätzen in der Oberfläche weiter vergrößert ist.

4. Bauelement nach einem der vorhergehenden Ansprüche,
bei dem sich über dem Verlustwärme erzeugenden Element eine Abdeckschicht (CL) erstreckt, auf der die Wärmeabstrahlschicht (ASS) angeordnet ist.

5. Bauelement nach dem vorhergehenden Anspruch,
bei dem die Abdeckschicht (CL) Teil einer Dünnfilm-Einheit, Thin Film Package, ist, die direkt auf dem die Bauelementstrukturen (BES) tragenden Chip (CH) erzeugt ist und die eine Kavität für das Verlustwärme erzeugende Element ausbildet.

6. Bauelement nach dem vorhergehenden Anspruch,
bei dem die Abdeckschicht (CL) über der Kavität aufliegt und neben der Kavität mit der Oberfläche des Chips abschließt.

7. Bauelement nach einem der vorhergehenden Ansprüche,
bei dem der Chip einen BAW oder FBAR Resonator umfasst,
bei dem die Wärmeabstrahlschicht (ASS) direkt auf die oberste Schicht des BAW oder FBAR Resonators aufgebracht ist.

8. Bauelement nach einem der vorhergehenden Ansprüche,
bei dem der Chip ein piezoelektrisches Substrat und darauf angeordnete Bauelementstrukturen (BES) umfasst, die zur Erzeugung, Wandlung, Propagation oder Reflexion von akustischen Oberflächenwellen - SAW - ausgebildet sind,
bei dem die Wärmeabstrahlschicht (ASS) direkt auf das Substrat im ersten Oberflächenbereich (SA1) neben den Bauelementstrukturen (BES) aufgebracht ist, wobei der erste Oberflächenbereich sich nicht in den akustischen Pfad der Oberflächenwellen erstreckt.

9. Bauelement nach einem der Ansprüche 1-7,
bei dem der Chip ein Halbleitersubstrat und darauf angeordnete und/oder darin integrierte Bauelementstrukturen (BES) umfasst,
bei dem der Chip ein Halbleiter-Bauelement darstellt.

10. Bauelement nach Anspruch 9,
bei dem der Chip eine integrierte Schaltung umfasst.

11. Bauelement nach einem der Ansprüche 1-7,
bei dem der Chip einen BAW oder FBAR Resonator umfasst.

12. Bauelement nach einem der vorhergehenden Ansprüche,
bei dem der Chip in Flip Chip Anordnung auf einem Träger so montiert ist, dass die Oberfläche mit den Bauelementstrukturen (BES) und die Abstrahlschicht (ASS) zum Träger (TR) weist,
bei dem auf der zum Chip (CH) weisenden Oberfläche des Trägers (TR) eine weitere Wärmeabstrahlschicht (ASSW) aufgebracht ist.

## Claims

1. An electrical component with improved heat dissipation, comprising
a chip (CH) having a loss heat generating element;
an on-chip heat radiation layer (ASS) placed in thermal contact with the loss heat generating element,
wherein the heat radiation layer has a roughened surface;
in which the radiation layer (ASS) is applied to a first surface area (SA1) of the chip,
wherein the loss heat generating element is arranged on a second surface area (SA2) of the chip,
wherein the first and second surface areas are arranged side by side; and
wherein an additional heat conducting layer (WLS) extends over the first and second surface area (SA1, SA2), which forms a heat dissipation path on the chip (CH) but below the radiation layer (ASS) and the loss heat generating element.

2. Component according to claim 1, in which the heat radiation layer (ASS) comprises a columnar structure and is designed as a polycrystalline or crystalline layer.

3. Component according to claim 2, wherein the heat radiation layer (ASS) is an AlN layer which is further enlarged by crystal axis-oriented etching back in the surface.

4. Component according to one of the preceding claims, wherein a covering layer (CL), on which the heat radiation layer (ASS) is arranged, extends over the loss heat generating element.

5. Component according to the preceding claim, wherein the cover layer (CL) is part of a thin film package which is directly formed on the chip (CH) carrying the device structures (BES) and which forms a cavity for the loss heat generating element.

6. Component according to the preceding claim, wherein the covering layer (CL) rests over the cavity and terminates adjacent to the cavity with the surface of the chip.

7. Component according to one of the preceding claims, in which the chip comprises a BAW or FBAR resonator, in which the heat radiation layer (ASS) is applied directly to the uppermost layer of the BAW or FBAR resonator.

8. Component according to one of the preceding claims, in which the chip comprises a piezoelectric substrate and component structures (BES) arranged thereon, which are designed for the generation, conversion, propagation or reflection of surface acoustic waves - SAW - in which the heat radiation layer (ASS) is applied directly to the substrate in the first surface area (SA1) adjacent to the component structures (BES), wherein the first surface are does not extend into the acoustic path of the surface waves.

9. Component according to one of claims 1 to 7, in which the chip comprises a semiconductor substrate and component structures (BES) arranged thereon and / or integrated therein, in which the chip is a semiconductor component.

10. Component according to claim 9, wherein the chip comprises an integrated circuit.

11. Component according to one of the claims 1 - 7, wherein the chip comprises a BAW or FBAR resonator.

12. Component according to one of the preceding claims, in which the chip is mounted in a flip-chip arrangement on a carrier in such a way that the surface with the component structures (BES) and the heat radiation layer (ASS) faces the carrier (TR), wherein a further heat radiation layer (ASSW) is applied to the surface of the carrier (TR) facing the carrier (CH).

## Revendications

1. Composant électrique à dissipation thermique améliorée, avec une puce (CH) qui comprend un élément générant une perte de chaleur,
avec une couche de rayonnement de chaleur (ASS) appliquée sur la puce qui est en contact thermique avec l'élément générant une perte de chaleur,
dans lequel la couche de rayonnement de chaleur présente une surface rugueuse ;
dans lequel la couche de rayonnement de chaleur (ASS) est appliquée sur une première zone superficielle (SA₁) de la puce,
dans lequel l'élément générant une perte de chaleur est disposé sur une deuxième zone superficielle (SA₂) de la puce,
dans lequel une première et une deuxième zone superficielle sont disposées côte à côte ; et
dans lequel une couche d'acheminement de chaleur (WLS) supplémentaire s'étend au-dessus de la première et de la deuxième zone superficielle (SA₁, SA₂), qui réalise sur la puce (CH) toutefois sous la couche de rayonnement de chaleur (ASS) et l'élément générant une perte de chaleur, un chemin de dissipation de chaleur.

2. Composant selon la revendication 1,
dans lequel la couche de rayonnement de chaleur (ASS) présente une structure en colonnes et est réalisée en tant que couche polycristalline ou cristalline.

3. Composant selon la revendication 2,
dans lequel la couche de rayonnement de chaleur (ASS) est une couche d'AlN, qui est agrandie encore par une rétrogravure orientée sur l'axe cristallographique dans la surface.

4. Composant selon l'une des revendications précédentes,
dans lequel une couche de recouvrement (CL) s'étend au-dessus de l'élément générant une perte de chaleur, sur laquelle la couche de rayonnement de chaleur (ASS) est disposée.

5. Composant selon la revendication précédente,
dans lequel la couche de recouvrement (CL) fait partie d'un ensemble à film mince, Thin Film Package, qui est produit directement sur la puce (CH) supportant les structures de composant (BES) et qui forme une cavité pour l'élément générant une perte de chaleur.

6. Composant selon la revendication précédente,
dans lequel la couche de recouvrement (CL) repose au-dessus de la cavité et se termine à côté de la cavité par la surface de la puce.

7. Composant selon l'une des revendications précédentes,
dans lequel la puce comprend un résonateur BAW ou FBAR, dans lequel la couche de rayonnement de chaleur (ASS) est appliquée directement sur la couche la plus haute du résonateur BAW ou FBAR.

8. Composant selon l'une des revendications précédentes,
dans lequel la puce comprend un substrat piézoélectrique et des structures de composant (BES) disposées sur celui-ci qui sont réalisées pour générer, convertir, propager ou réfléchir des ondes acoustiques de surface -SAW-,
dans lequel la couche de rayonnement de chaleur (ASS) est appliquée directement sur le substrat dans la première zone superficielle (SA₁) à côté des structures de composant (BES),
dans lequel la première zone superficielle ne s'étend pas sur le chemin acoustique des ondes de surface.

9. Composant selon l'une des revendications 1 à 7,
dans lequel la puce comprend un substrat semi-conducteur et des structures de composant (BES) disposées sur celui-ci et/ou intégrées à celui-ci,
dans lequel la puce constitue un composant semi-conducteur.

10. Composant selon la revendication 9,
dans lequel la puce comprend un circuit intégré.

11. Composant selon l'une des revendications 1 à 7,
dans lequel la puce comprend un résonateur BAW ou FBAR.

12. Composant selon l'une des revendications précédentes,
dans lequel la puce est montée selon un agencement de type flip-chip sur un support de telle sorte que la surface avec les structures de composant (BES) et la couche de rayonnement (ASS) soient tournées vers le support (TR), dans lequel une autre couche de rayonnement de chaleur (ASSW) est appliquée sur la surface du support (TR) tournée vers la puce (CH).
